Europäisches Patentamt

(19) European Patent Office

Office européen des brevets

(11) Veröffentlichungsnummer: **0 002 840**
**B1**

(12) **EUROPÄISCHE PATENTSCHRIFT**

(51) Int. Cl.³: **H 01 L 29/08**, H 01 L 29/52, H 01 L 29/743

(45) Veröffentlichungstag der Patentschrift:
05.08.81

(21) Anmeldenummer: **78200136.6**

(22) Anmeldetag: **07.08.78**

(54) Kathodenseitig steuerbarer Thyristor mit einer Anodenzone aus zwei aneinandergrenzenden Bereichen mit unterschiedlicher Leitfähigkeit.

(30) Priorität: **21.12.77 CH 15759/77**

(43) Veröffentlichungstag der Anmeldung:
**11.07.79 Patentblatt 79/14**

(45) Bekanntmachung des Hinweises auf die Patenterteilung:
**05.08.81 Patentblatt 81/31**

(84) Benannte Vertragsstaaten:
**FR GB SE**

(56) Entgegenhaltungen:
**CH-A-542 515**
**DE-A-1 614 500**
**DE-A-2 628 793**
**FR-A-1 461 972**
**FR-A-2 247 824**
**US-A-2 993 154**

(73) Patentinhaber: **BBC Brown, Boveri & Cie.
(Aktiengesellschaft), CH-5401 Baden (CH)**

(72) Erfinder: **Sittig, Roland, Dr. Phys., Rinikerstrasse 102,
CH-5222 Umiken (CH)**

Kathodenseitig steuerbarer Thyristor mit einer Anodenzone aus zwei
aneinandergrenzenden Bereichen mit unterschiedlicher Leitfähigkeit.

Die Erfindung betrifft einen kathodenseitig steuerbaren Thyristor mit auf der Kathodenfläche verteilten Emitterkurzschlüssen, bei dem die Anodenzone des Thyristors entlang ihrer oberseitigen Randzone zwei aneinandergrenzende Bereiche unterschiedlicher Dotierung aufweist.

Ein solcher Thyristor ist mindestens aus der DE-A-1 614 500 bekannt. Weiter ist aus der CH-A-542 512 ein kathodenseitig steuerbarer Thyristor bekannt, bei dem die Anodenzone des Thyristors entlang ihrer oberseitigen Randzone zwei aneinandergrenzende Bereiche unterschiedlicher Dotierung aufweist und bei dem der niedriger dotierte Bereich der anode mindestens dem Gate gegenüberliegt.

Bei diesen Thyristoren wird als Zündanordnung eine geeignete Strukturierung des Gate-Kathoden-Bereichs verwendet. Für derartige Anordnungen sind die zur Einstellung des gewünschten Zündstromes bei vorgegebener Spannung- und Stromanstiegsgeschwindigkeit erforderlichen Strukturparameter bekannt (vgl. z. B. Hartmann, in: IEEE ED-23, August 1976, S. 912–917), bei der praktischen Ausführung ergeben sich jedoch durch technologische Beschränkungen und die gegenseitige Verkopplung verschiedener Eigenschaften bedingte Schwierigkeiten. Insbesondere muss für die Anordnung der am nächsten beim gateseitigen Kathodenrand liegenden Emitterkurzschlüsse zwischen genügender dU/dt-Festigkeit und möglichst grosser Stromanstiegsgeschwindigkeit, dI/dt., ein Kompromiss gefunden werden.

Es ist darum die Aufgabe der vorliegenden Erfindung, einen Thyristor zu schaffen, bei dem die maximal noch zulässige Stromanstiegsgeschwindigkeit, dI/dt, mindestens um den Faktor 2 höher liegt als bei den einleitend genannten Thyristoren.

Diese Aufgabe wird erfindungsgemäss dadurch gelöst, dass der niedrigerdotierte Bereich dem Gate und mindestens dem gateseitigen Kathodenemitterrandbereich gegenüberliegt und dass nur der höherdotierte Bereich mit einer Anodenmetallisierung versehen ist.

Durch diese Massnahmen wird erreicht, dass sich nicht – wie bei bekannten Thyristoren – unterhalb des gateseitigen Kathodenrandes ein Zündkanal bildet, sondern dass die Zündung erst in dem Bereich des anodenseitigen hochdotierten Bereichs- bzw. Metallisierungsrandes erfolgt, und zwar sowohl aufgrund des ohmschen elektrischen Feldes als auch aufgrund des begrenzten Injektionsvermögens.

Eine derartig aufgebaute Anodenzone ist auch bei anderen Gatestrukturen wie Amplifying Gate und Junction Gate vorteilhaft verwendbar.

Besonders vorteilhaft ist die neue Struktur der Anodenzone bei solchen Thyristoren, bei denen die gatenächsten Emitterkurzschlüsse einen zusammenhängenden Ring bilden. Ausser der grösseren Stromanstiegsgeschwindigkeit weisen derartige Thyristoren eine besonders hohe dU/dt-Festigkeit auf. Allerdings würde bei herkömmlichen Thyristoren die sich ausbreitende Zündfront an dem Kurzschlussring aufgehalten und dadurch bei hohem dI/dt der Thyristor zerstört werden. Bei dem neuen Thyristor hingegen wird aufgrund der Tatsache, dass durch das beim Zünden an der Anode erzeugte Querfeld die Löcherinjektion an den Rand des hochdotierten Bereiches verlagert wird, der Kurzschlussring von der Zündfront übersprungen. Voraussetzung ist allerdings, dass der höherdotierte Anodenbereich demjenigen Teil des Kathodenemitters gegenüberliegt, der sich ausserhalb des Emitterkurzschlussringes befindet.

Um die zulässige Strombelastung des Thyristors nicht merklich zu verändern, kann der Durchmesser des inneren Randes des höherdotierten Anodenbereiches nicht beliebig gross gewählt werden sondern er liegt vorzugsweise denjenigen Stellen des Kathodenemitters gegenüber, die sich zwischen den gatenächsten Emitterkurzschlüssen und den jeweils nächsten weiter aussen liegenden Kurzschlüssen befinden.

Sind die einzelnen Emitterkurzschlüsse ringförmig um das Gate (Steuerelektrode) herum angeordnet, so liegt der innere Rand des höherdotierten Bereichs vorzugsweise jeweils denjenigen Stellen des Kathodenemitters gegenüber, die durch den von dem Gatemittelpunkt gemessenen Abstands: $R_{S1} + D/2$ definiert sind, wobei $R_{S1}$ den Radius des Ringes auf die die gatenächsten Emitterkurzschlüsse liegen bedeutet und mit D der Abstand bezeichnet ist zwischen $R_{S1}$ und dem Ring $R_{S2}$, auf dem die jeweils nächsten Emitterkurzschlüsse liegen.

Die vorgeschlagene Anordnung bietet also einen zusätzlichen Freiheitsgrad bei der Dimensionierung von Gatestrukturen. Die Anordnung enthält überdies intern zündverstärkende Eigenschaften, wie sie auch der bekannte Kathoden-Querfeldemitter aufweist (vgl. J. Burtscher: Thyristoren mit innerer Zündverstärkung, in: Dynamische Probleme der Thyristortechnik; VDE-Verlag (1971; S. 128ff). Sie lässt sich darüber hinaus aber auch mit anderen bekannten Strukturen kombinieren, wie etwa mit einem Amplifying Gate oder mit einem Junction Gate (vgl. hierzu ebenfalls den vorstehend zitierten Aufsatz von J. Burtscher).

Im folgenden werden Ausführungsbeispiele des neuen Thyristors anhand der Zeichnung erläutert, aus denen weitere Vorteile der Erfindung hervorgehen.
Es zeigt

Fig. 1 einen Ausschnitt auf eine Draufsicht auf einen Thyristor mit einem symmetrisch zum Gate liegenden Emitterkurzschlussring (aus Gründen der Übersicht wurde die Kontaktmetallisierung der Kathode und des Gates weggelassen);

Fig. 2 eine Schnittzeichnung durch den Thyristor nach Fig. 1 längs der Linie s–s in vergrösserter Darstellung und mit Kathoden-, Anoden- und Gatekontaktmetallisierung;

Fig. 3 den Dotierungsverlauf für einen Thyristor nach Fig. 2.

Fig. 4 eine Schnittzeichnung durch einen Thyristor mit Junction Gate.

In allen Figuren beziehen sich gleiche Bezugszeichen auf gleiche Teile.

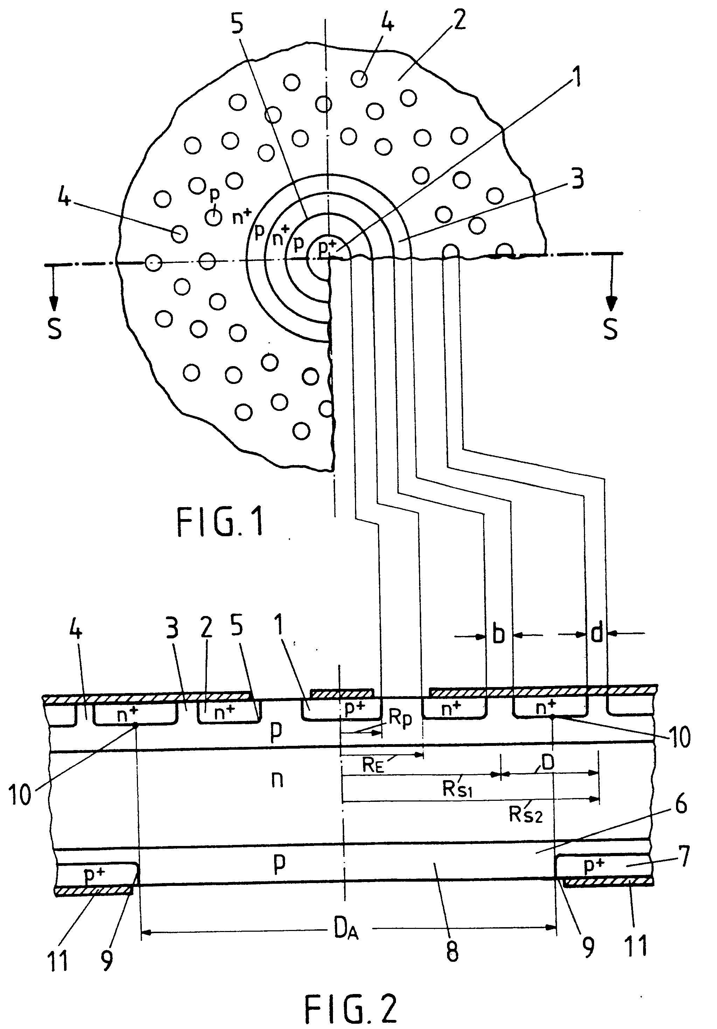

In Fig. 1 sind mit 1 das Gate, mit 2 die Kathodenemitterzone, mit 3 der Emitterkurzschlussring und mit 4 einzelne Emitterkurzschlusspunkte bezeichnet. Zwischen dem gateseitigen Emitterzonenrand 5 und dem Rand des Gates 1 ist ein Teil der P-Basiszone sichtbar, in die das hochdotierte ($p^+$–) Gate 1 eingebettet ist (vgl. auch Fig. 2). Der Abstand der dem Emitterkurzschlussring 3 nächsten Kurzschlüsse 4 kann grösser sein, als der Abstand der weiter aussen liegenden Emitterkurzschlüsse 4 voneinander.

Die Zonenfolge und die Struktur der Anodenzone 6 sowie die Struktur der Kontaktmetallisierung von Gate, Emitter- und Anodenzone sind aus Fig. 2 ersichtlich. Dabei ist die Anodenmetallisierung mit 11 gekennzeichnet. Die p-dotierte Anodenzone 6 weist an ihrer oberseitigen Randzone die Bereiche 7 und 8 auf, wobei die Störstellenkonzentration an der Oberfläche der Halbleiterscheibe im Bereich 7 hoch, hingegen im Bereich 8 wesentlich geringer ist.

Der Rand 9 des hochdotierten ($p^+$–) Bereichs 7 liegt gemäss der Erfindung etwa gegenüber denjenigen Stellen 10 des Emitters 2, die durch den Abstand $R_{s1}$ + D/2 vom Gatemittelpunkt definiert sind.

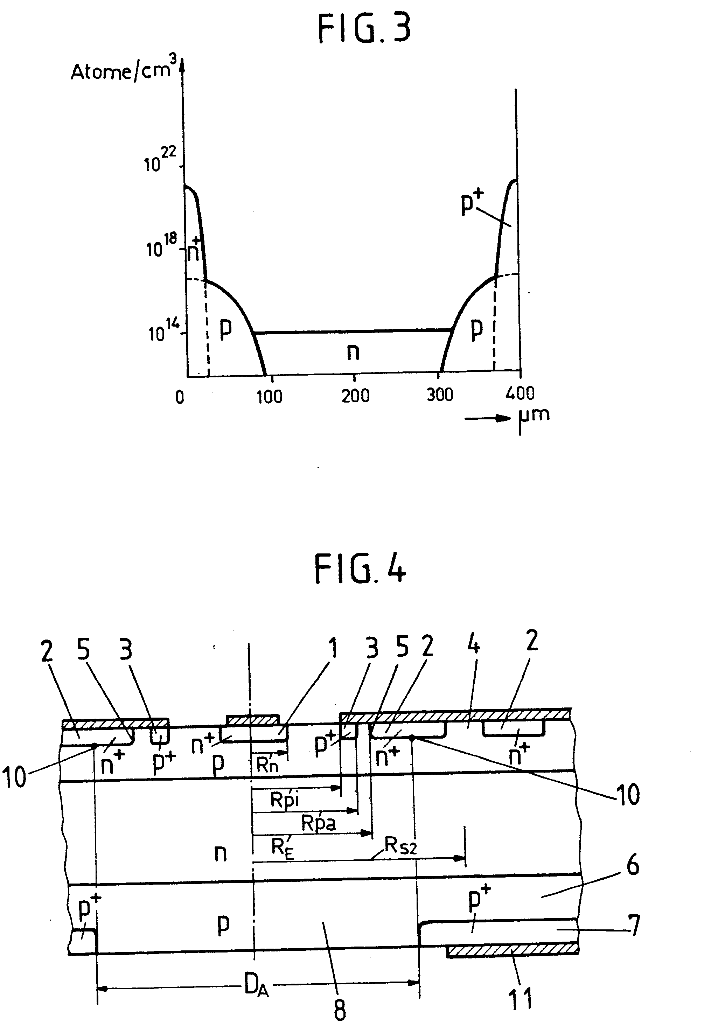

Fig. 3 zeigt ein Dotierungsprofil (Störstellenkonzentration als Funktion der Eindringtiefe), wie es beispielsweise bei den neuen Thyristoren verwendet werden kann. Die Dicke der Halbleiterscheibe des Thyristors beträgt 450 $\mu$m. Die Störstellenkonzentration an der anodenseitigen Oberfläche ist im Bereich 7 etwa $5 \cdot 10^{20}$ Atome/cm³, im Bereich 8 etwa $5 \cdot 10^{16}$ Atome/cm³. Die Störstellenkonzentrationen an der kathodengateseitigen Oberfläche ist sowohl in den Emitterbereichen ($n^+$-Dotierung) als auch in den Emitterkurzschluss- und Gatebereich ($p^+$-Dotierung) etwa $10^{20}$ Atome/cm³. Die Tiefe der jeweiligen Dotierung gemessen von der kathodenseitigen Oberfläche beträgt für das Gate 1 und den Kathodenemitter 2 etwa 15 $\mu$m. Die laterale Struktur (vgl. Fig. 1 und 2) wies bei diesem Thyristor folgende Werte auf:

Radius vom Mittelpunkt des Gates bis
— zum Rand des Gates (Rp): 1500 $\mu$m
— zum Rand des Emitters ($R_E$): 1800 $\mu$m
— zur Mitte des Kurzschlussringes ($R_{s1}$): 2300 $\mu$m
— zur Mitte der nächsten Emitterkurzschlüsse ($R_{s2}$): 3600 $\mu$m

Breite des Emitterkurzschlussringes (b): 200 $\mu$m
Durchmesser des einzelnen Kurzschlusslochs (d): 200 $\mu$m
Durchmesser des niedrigdotierten Bereichs ($D_A$): 5700 $\mu$m

Die dem Emitterkurzschlussring 3 nächsten 18 Kurzschlusslöcher 4 werden gleichmässig auf dem Ring mit dem Radius $R_{S2}$ vom Gatemittelpunkt angeordnet. Von diesem Ring aus können die weiter aussen liegenden Emitterkurzschlüsse 4 eine hexagonale Anordnung aufweisen. Die Entfernung der einzelnen Emitterkurzschlüsse 4 voneinander soll dabei nicht mehr als 1200 $\mu$m betragen.

Die mit diesem Thyristor gemessene noch zulässige Stromanstiegsgeschwindigkeit, dI/dt, betrug 300 A/$\mu$s und war damit mehr als doppelt so hoch wie bei gleich dimensionierten Thyristoren mit normaler Gateanordnung und gleicher Kathodenrandlänge.

Fig. 4 zeigt ein weiteres Ausführungsbeispiel: Einen Thyristor mit einem sogenannten Junction Gate, d. h. einem Gate mit $n^+$-Dotierung. Der Emitterkurzschlussring 3 liegt in diesem Fall dem Gate 1 näher als der gateseitige Kathodenrand 5, wodurch eine besonders hohe dU/dt-Festigkeit erzielt wird. Das Dotierungsprofil entsprach im wesentlichen dem in Fig. 3 wiedergegebenen Profil. Für die laterale Struktur ergaben sich folgende Werte:
Radius vom Mittelpunkt des Gates bis
— zum Rand des Gates ($R_n$) + 1500 $\mu$m
— zum $p^+$-Emitterschlussring, innen (Rpi: 1600 $\mu$m
— zum $p^+$-Emitterkurzschlussring, aussen (Rpa): 1750 $\mu$m
— zum $n^+$-Kathodeninnenrand ($R_E$): 1800 $\mu$m
— zur Mitte der nächsten Emitterkurzschlüsse ($R_{S2}$): 3000 $\mu$m
Durchmesser des niedrigdotierten Bereichs ($D_A$): 4500 $\mu$m
Auf dem Ring mit dem Radius $R_{S2}$ werden 16 Kurzschlusslöcher gleichmässig angeordnet. Der Durchmesser eines einzelnen Kurzschlusslochs 4 beträgt wiederum 200 $\mu$m.

Die vorliegende Erfindung ist selbstverständlich nicht auf Thyristoren mit kreissymmetrischen Gate- und Emitterstrukturen beschränkt sondern kann beispielsweise auch bei Thyristoren mit fingerförmigem oder quadratischem Gate verwendet werden.

**Patentansprüche**

1. Kathodenseitig steuerbarer Thyristor mit auf der Kathodenfläche verteilten Emitterkurzschlüssen, bei dem die Anodenzone (6) des Thyristors entlang ihrer oberseitigen Randzone zwei aneinandergrenzende Bereiche (7, 8) unterschiedlicher Dotierung aufweist, dadurch gekennzeichnet, dass der niedrigerdotierte Bereich (8) dem Gate (1) und mindestens dem gateseitigen Kathodenemitterrandbereich gegenüberliegt und dass nur der höherdotierte Bereich (7) mit einer Anodenmetallisierung (11) versehen ist.

2. Thyristor nach Anspruch 1, dadurch gekennzeichnet, dass der höherdotierte Bereich (7) demjenigen Teil des Kathodenemitters (2) gegenüberliegt, der sich ausserhalb des durch die Verbindung der gatenächsten Emitterkurzschlüsse bildenden Polygonzugs befindet.

3. Thyristor nach Anspruch 2, dadurch gekennzeichnet, dass die einzelnen Emitterkurzschlüsse ringförmig um das Gate (1) herum angeordnet sind und dass der innere Rand (9) des höherdotierten Bereichs (7) jeweils denjenigen Stellen (10) des Kathodenemitters (2) gegenüberliegt, die durch den von dem Gatemittelpunkt gemessenen Abstand $R_{S1}$+D/2 definiert sind, wobei $R_{S1}$ der mittlere Radius des Ringes, auf dem die gatenächsten Emitterkurzschlüsse liegen, bedeutet und mit D der Abstand bezeichnet ist zwischen dem Radius $R_{S1}$ und dem Radius $R_{S2}$ des Ringes, auf dem die jeweils nächsten Emitterkurzschlüsse liegen.

4. Thyristor nach Anspruch 2 und 3, dadurch gekennzeichnet, dass die gatenächsten Emitterkurzschlüsse einen zusammenhängenden Emitterkurzschlussring (3) bilden.

5. Thyristor nach Anspruch 4, dadurch gekennzeichnet, dass der Ring, auf dem die dem Emitterkurzschlussring (3) nächsten Emitterkurzschlüsse (4) liegen, einen Abstand aufweist, der grösser ist als der Abstand zwischen den weiter aussen liegenden Emitterkurzschlüssen (4).

6. Thyristor nach Anspruch 1 bis 5, dadurch gekennzeichnet, dass der Thyristor ein Amplifying aufweist.

7. Thyristor nach Anspruch 1 bis 5, dadurch gekennzeichnet, dass der Thyristor ein Junction Gate aufweist.

## Claims

1. Thyristor which can be controlled on the cathode side and has emitter short-circuits distributed over the surface of the cathode and in which the anode zone (6) contains, along its top edge zone, two adjacent regions (7, 8) of different doping, characterised in that the less highly doped region (8) is located opposite the gate (1) and at least opposite the cathode emitter edge region on the gate side, and that only the more highly doped region (7) is provided with an anode metallisation (11).

2. Thyristor according to Claim 1, characterised in that the more highly doped region (7) is located opposite that part of the cathode emitter (2) which is located outside the chain of polygons formed by the connection of the emitter short-circuits nearest to the gate.

3. Thyristor according to Claim 2, characterised in that the individual emitter short-circuits are arranged in the form of a ring around the gate (1), and that the inner edge (9) of the more highly doped region (7) is in each case located opposite those points (10) of the cathode emitter (2) which are defined by a distance of $R_{S1}$ + D/2 measured from the centre of the gate, $R_{S1}$ being the mean radius of the ring on which the emitter short-circuits nearest to the gate are located, and D designating the distance between the radius $R_{S1}$ and the radius $R_{S2}$ of the ring on which the nearest emitter short-circuits in each case are located.

4. Thyristor according to Claim 2 and 3, characterised in that the emitter short-circuits nearest to the gate form a coherent emitter short-circuit ring (3).

5. Thyristor according to Claim 4, characterised in that the ring on which the emitter short-circuits (4) nearest to the emitter short-circuit ring (3) are located has a spacing which is greater than the distance between the emitter short-circuits (4) which are located further outwards.

6. Thyristor according to Claim 1 to 5, characterised in that the thyristor has an amplifying gate.

7. Thyristor according to Claim 1 to 5, characterised in that the thyristor has a junction gate.

## Revendications

1. Thyristor pouvant être commandé par la cathode comportant des courts-circuits d'émetteur répartis sur la surface de la cathode, la zone d'anode (6) du thyristor présentant, le long de sa zone superficielle supérieure, deux domaines (7, 8) contigus à dopages différents, caractérisé en ce que le domaine (8) plus faiblement dopé se situe en face de la porte (1) et au moins du domaine de la limite d'émetteur de cathode du côté de la porte et seul le domaine (7) plus fortement dopé est pourvu d'une métallisation d'anode (11).

2. Thyristor suivant la revendication 1, caractérisé en ce que le domaine plus fortement dopé (7) se situe en face de la partie de l'émetteur de cathode (2) qui se trouve à l'extérieur du tracé polygonal formé par la liaison des courts-circuits d'émetteur les plus proches de la porte.

3. Thyristor suivant la revendication 2, caractérisé en ce que les courts-circuits d'émetteur individuels sont disposés en anneau autour de la porte (1), et la limite interne (9) du domaine plus fortement dopé (7) se situe en face des endroits (10) de l'émetteur de cathode (2) qui sont définis par la distance: $R_{S1}$ + D/2 mesurée à partir du point central de la porte, $R_{S1}$ étant le rayon moyen de l'anneau sur lequel sont situés les courts-circuits d'émetteur les plus proches de la porte et D étant la distance entre le rayon $R_{S1}$ et le rayon $R_{S2}$ de l'anneau sur lequel sont situés les courts-circuits d'émetteur suivants.

4. Thyristor suivant les revendications 2 et 3, caractérisé en ce que les courts-circuits d'émetteur les plus proches de la porte forment un anneau de courts-circuits d'émetteur (3) cohérent.

5. Thyristor suivant la revendication 4, caractérisé en ce que l'anneau sur lequel se trouvent les courts-circuits d'émetteur (4) les plus proches de l'anneau de courts-circuits d'émetteur (3), présente une distance qui est supérieure à la distance entre les courts-circuits d'émetteur (4) disposés davantage vers l'extérieur.

6. Thyristor suivant les revendications 1 à 5, caractérisé en ce qu'il présente une porte amplificatrice.

7. Thyristor suivant les revendications 1 a 5, caractérisé en ce qu'il présente une porte à jonction.

FIG.1

FIG.2

# FIG.3

# FIG.4